# EUROPEAN PATENT APPLICATION

(11) **EP 2 763 188 A1**
(43) Date of publication of application: **06.08.2014**
(21) Application number: 12837549.0
(22) Date of filing: 09.04.2012
(51) Int. Cl.: H01L 31/042

(54) **SOLAR CELL MODULE**

(30) Priority: 29.09.2011 JP 2011213704
(71) Applicant: Sanyo Electric Co., Ltd., Osaka 570-8677 (JP)
(72) Inventor: TABE, Tomonori, Moriguchi-shi Osaka 570-8677 (JP); KUDOH, Yoshiyuki, Moriguchi-shi Osaka 570-8677 (JP); ISHII, Yousuke, Moriguchi-shi Osaka 570-8677 (JP); MORIKAWA, Ryota, Moriguchi-shi Osaka 570-8677 (JP); FUKUMOCHI, Shuji, Moriguchi-shi Osaka 570-8677 (JP)
(74) Representative: Glawe, Delfs, Moll
(86) International application number: PCT/JP2012/059629
(87) International publication number: WO 2013/046773

(57) **Abstract**

A solar module with improved output characteristics is provided. The solar module (1) includes a photoelectric conversion unit (23), a solar cell (20) having a first electrode (21) and a second electrode (22), and a wiring member (32a). The wiring member (32a) has resin film (51) and wiring (52) arranged on the resin film (51). The wiring member (32a) has a first portion (32a1), a second portion (32a2) and a bent portion (32a3). The first portion (32a1) is arranged so the wiring (52) faces the solar cell (20) side. The first portion (32a1) is bonded to the solar cell (20). The second portion (32a2) is arranged so the wiring (52) faces the reverse side from the solar cell (20). The bent portion (32a3) connects the first portion (32a1) and the second portion (32a2). The bent portion (32a3) is arranged on the solar cell (20).

## Description

### FIELD OF THE INVENTION

The present invention relates to a solar module.

### BACKGROUND

Solar modules having back contact solar cells are known to be solar modules with better photoelectric conversion efficiency. An example is described in Patent Document 1. The solar module described in Patent Document 1 includes a plurality of back contact solar cells, and a circuit board with wiring arranged on the surface. The solar cells are installed in one direction on the circuit board with the back surface sides of the solar cells facing the circuit board, and are connected electrically to the circuit board. The circuit board is bent in the direction opposite the solar cells to the outside of the area in which the solar module is provided.

### Prior Art Documents

### Patent Documents

Patent Document 1: Laid-Open Patent Publication No. 2009-43842

### SUMMARY

### Problem Solved by the Invention

In recent years, there has been growing demand for solar modules with even better output characteristics.

### Means of Solving the Problem

The solar module in the present invention includes a solar cell and a wiring member. The solar cell has a photoelectric conversion unit, a first electrode, and a second electrode. The photoelectric conversion unit has a first main surface and a second main surface. The first electrode and the second electrode are arranged on the second main surface. The wiring member has resin film and wiring. The wiring is arranged on the resin film. The wiring is connected electrically to the first electrode and the second electrode. The wiring member has a first portion, a second portion, and a bent portion. The first portion is arranged so that the wiring faces the solar cell side. The first portion is bonded to the solar cell. The second portion is arranged so that the wiring is facing the reverse side from the solar cell. The bent portion is connected to the first portion and the second portion. The bent portion is arranged on the solar cell.

### Effect of the Invention

The present invention is able to provide a solar module with improved output characteristics.

### BRIEF DESCRIPTION OF THE DRAWINGS

FIG. 1 is a simplified rear view of the solar module in an embodiment.
FIG. 2 is a simplified cross-sectional view from line II-II in FIG. 1.
FIG. 3 is a simplified rear view of a solar cell in the embodiment.
FIG. 4 is a simplified cross-sectional view of the solar cell string in section IV of FIG. 2.
FIG. 5 is a simplified cross-sectional view of the solar cell string in section V of FIG. 2.
FIG. 6 is an expanded view of the wiring member 32 in a modified example.

### DETAILED DESCRIPTION

The following is an explanation of examples of preferred embodiments of the present invention. The following embodiments are merely examples. The present invention is not limited by the following embodiments in any way.

Further, in each of the drawings referenced in the embodiments, members having substantially the same function are denoted by the same symbols. The drawings referenced in the embodiments are also depicted schematically. The dimensional ratios of the objects depicted in the drawings may differ from those of the actual objects. The dimensional ratios of objects may also vary between drawings. The specific dimensional ratios of the objects should be determined with reference to the following explanation.

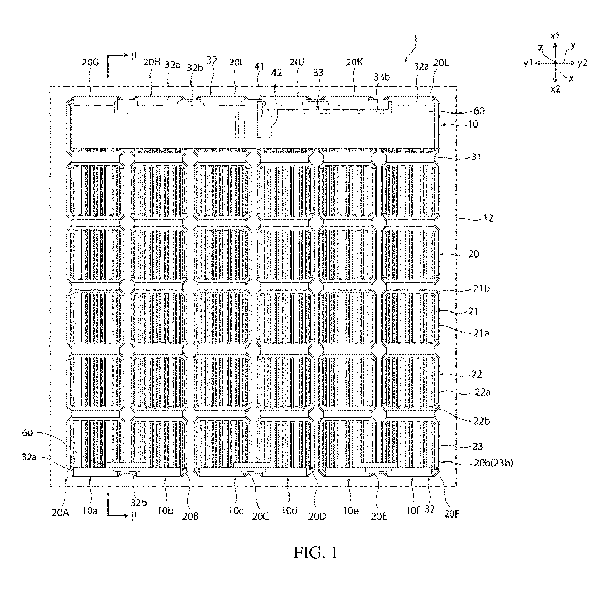

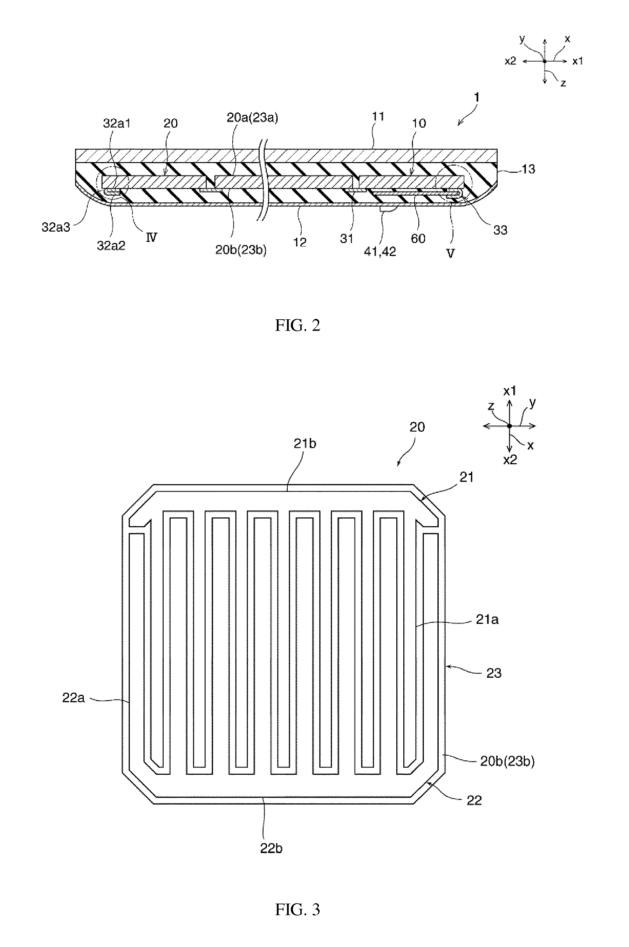

As shown in FIG. 1 and FIG. 2, the solar module 1 includes a plurality of solar cell strings 10 each having a plurality of solar cells 20. More specifically, the solar module 1 includes first through sixth solar cell strings 10a-10f. As shown in FIG. 2, the solar cell strings 10 are arranged between a first protecting member 11 and a second protecting member 12. The first protecting member 11 is positioned on the light-receiving surface 20a side of the solar cells 20. The second protecting member 12 is positioned on the back surface 20b side of the solar cells 20. The second protecting member 12 has flexible properties. A sealing material layer 13 is provided between the first protecting member 11 and the second protecting member 12. The solar cells 20 are sealed in the sealing material layer 13.

The first protecting member 11 can be composed of a translucent member such as a glass substrate or a resin substrate. The second protecting member 12 can be composed of a flexible member such as a resin sheet or a resin sheet containing interposed metal foil. The sealing material layer 13 can be composed of a resin such as an ethylene-vinyl acetate (EVA) copolymer, polyvinyl butyral (PVB), polyethylene (PE) or polyurethane (PU). The sealing material layer 13 preferably includes a non-crosslinked resin.

Each of the solar cell strings 10 has a plurality of solar cells 20 arranged in the x-axis direction. As shown in FIG. 1 and FIG. 3, each solar cell 20 has a photoelectric conversion unit 23, a first electrode 21, and a second electrode 22.

The photoelectric conversion unit 23 has a first main surface 23a and a second main surface 23b. The first main surface 23a of the photoelectric conversion unit 23 comprises the light-receiving surface 20a of the solar cell 20, and the second main surface 23b comprises the back surface 20b of the solar cell 20.

The photoelectric conversion unit 23 is the member that generates carriers such as holes or electrons when exposed to light. Carriers may be generated by the photoelectric conversion unit 23 when light is incident only on the first main surface 23a, or when light is incident on both the first main surface 23a and on the second main surface 23b. In other words, the solar cells 20 may be bifacial solar cells.

There are no particular restrictions on the type of photoelectric conversion unit 23. The photoelectric conversion unit 23 can be composed, for example, of a crystalline silicon substrate.

A first electrode 21 for collecting one of either holes or electrons, and a second electrode 22 for collecting the other of either holes or electrodes are arranged on the second main surface 23b of the photoelectric conversion unit 23. Therefore, each solar cell 20 is a back contact solar cell.

There are no particular restrictions on the shape of the first electrode 21 and the second electrode 22. In the present embodiment, both the first electrode 21 and the second electrode 22 have a comb shape. The first electrode 21 and the second electrode 22 are interdigitated. More specifically, each of first electrode 21 and the second electrode 22 have a plurality of finger portions 21 a, 22a and busbar portions 21b, 22b. Each of the finger portions 21 a, 22a extends in the x-axis direction. The finger portions 21 a, 22a are interdigitated in the y-axis direction which is orthogonal to the x-axis direction.

The finger portions 21a are connected electrically to the busbar portion 21b. The busbar portion 21b is arranged on one side (the x1 side) of the finger portions 21a in the x-axis direction. The busbar portion 21b is provided on the x1 end portion of the solar cell 20 in the x-axis direction and extends from one end to the other end of the end portion in the y-axis direction.

More specifically, the finger portions 22a are connected electrically to the busbar portion 22b. The busbar portion 22b is arranged on the other side (the x2 side) of the finger portions 22a in the x-axis direction. The busbar portion 22b is provided on the x2 end portion of the solar cell 20 in the x-axis direction and extends from one end to the other of the end portion in the y-axis direction.

As shown in FIG. 1, a plurality of solar cells 20 are connected electrically via a first wiring member 31 in each of the solar cell strings 10. More specifically, the first electrode 21 of one solar cell 20 is connected electrically to the second electrode 22 of another adjacent solar cell 20 in the x-axis direction via a first wiring member 31.

The first wiring member 31 can be composed of a flexible printed circuit (FPC) board having metal foil of Ag or Cu, a laminate of metal foil, metal foil whose surface is coated with solder, insulating film, and wiring arranged on the insulating film.

The first wiring member 31 is bonded to the back surface 20b of the solar cell 20 via an adhesive layer (not shown). The adhesive layer can be composed of a cured resin adhesive, a cured resin adhesive containing a dispersed metal material, or solder.

The first through sixth solar cell strings 10a-10f are connected electrically via a second wiring member 32. More specifically, solar cell 20A positioned at the far x2 side of the first solar cell string 10a and solar cell 20B positioned at the far x2 side of the second solar cell string 10b, solar cell 20C positioned at the far x2 side of the third solar cell string 10c and solar cell 20D positioned at the far x2 side of the fourth solar cell string 10d, and solar cell 20E positioned at the far x2 side of the fifth solar cell string 10e and solar cell 20F positioned at the far x2 side of the sixth solar cell string 10f are connected to each other electrically via a second wiring member 32. The second wiring member 32 electrically connects the first electrode 21 of solar cells 20A, 20C and 20E to the second electrode 22 of solar cells 20B, 20D and 20F.

In addition, solar cell 20H positioned at the far x1 side of the second solar cell string 10b and solar cell 20I positioned at the far x1 side of the third solar cell string 10c, and solar cell 20J positioned at the far x1 side of the fourth solar cell string 10d and solar cell 20K positioned at the far x1 side of the fifth solar cell string 10e are connected to each other electrically via a second wiring member 32. The second wiring member 32 electrically connects the first electrode 21 of solar cells 20H and 20J to the second electrode 22 of solar cells 20I and 20K.

A first extraction electrode 41 is composed of a portion of the second wiring member 32 connected electrically to solar cells 20H and 20I, and a portion of the second wiring member 32 connected electrically to solar cells 20J and 20K. As shown in FIG. 2, the first extraction electrode 41 is drawn from the solar module 1. More specifically, the tip portion of the first extraction electrode 41 reaches the outside of the second protecting member 12.

The second wiring member 32 is composed of two wiring members 32a and a wiring member 32b. Each of the two wiring members 32a is bonded via an adhesive layer 40 to a solar cell 20 and is electrically connected to a first electrode 21 or a second electrode 22. The wiring member 32b is connected electrically to the two wiring members 32a. The wiring member 32a is arranged on one end portion of a solar cell 20 in one direction (the x-axis direction) so as to extend from the end on the y1 side to the end on the y2 side in the other direction (the y-axis direction) which is orthogonal to the one direction (the x-axis direction).

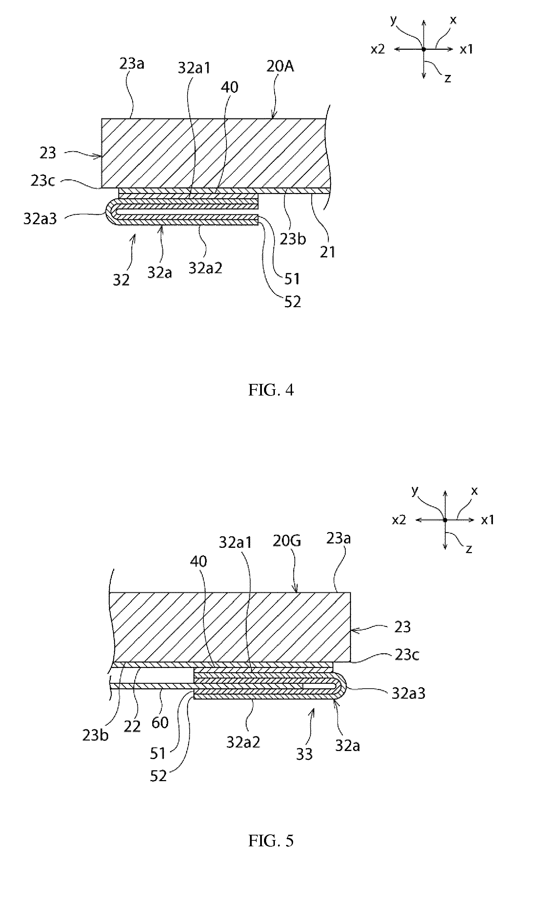

As shown in FIG. 4, wiring member 32a is composed of a flexible printed circuit board having resin film 51 and wiring 52. The resin film 51 can be made of a resin such as polyimide (PI) or polyethylene terephthalate (PET). The wiring 52 is arranged on the resin film 51. The wiring 52 is connected electrically to a first electrode 21 or a second electrode 22. The wiring 52 can be composed of metal foil containing at least one metal such as Cu or Ag.

The wiring member 32a has a first portion 32a1, a second portion 32a2, and a bent portion 32a3. The first portion 32a1 comprises the portion at one end of the wiring member 32a. The first portion 32a1 is arranged so that the wiring 52 faces the solar cell 20 side. The first portion 32a1 is bonded to the back surface 20b of the solar cell 20.

The second portion 32a2 comprises the portion at the other end of the wiring member 32a. The second portion 32a2 is arranged so that the wiring 52 faces the reverse side from the solar cell 20. At least some of the second portion 32a2 is arranged on the first portion 32a1. In other words, at least some of the second portion 32a2 overlaps with the first portion 32a1 in the z-axis direction, which is the thickness direction of the solar cell 20.

The bent portion 32a3 connects the first portion 32a1 to the second portion 32a2. The bent portion 32a3 has a bent structure. In the bent portion 32a3, the wiring 52 faces outward. The bent portion 32a3 is arranged on the back surface 20b of the solar cell 20. In other words, the bent portion 32a3 overlaps with the solar cell 20 in the z-axis direction. The bent portion 32a3 is the portion formed by bending a flat wiring member.

The wiring member 32b is connected electrically to the wiring 52 of the wiring member 32a in the second portion 32a2. Wiring member 32b may be bonded to wiring member 32a using a resin adhesive. However, in the present embodiment, it is bonded to the wiring member 32a using solder and is connected electrically to the wiring 52 of the wiring member 32a. The wiring member 32b is bonded to a portion of the wiring member 32a in the other direction (the y-axis direction). The ratio of the length of the bonded portion of wiring member 32a and wiring member 32b in the y-axis direction to the length of wiring member 32a in the y-axis direction ((length of bonded portion of wiring members 32a and 32b in y-axis direction)/(length of wiring member 32a in y-axis direction)) is preferably from 1/20 to 1, and more preferably from 1/20 to 1/2.

A portion of the wiring member 32b is composed of an extraction electrode 41, and is drawn from the solar module 1.

In the present embodiment, wiring member 32b is composed of metal foil made of at least one type of metal such as Cu or Ag. The thickness of the wiring member 32b is greater than the thickness of the wiring 52. The thickness of the wiring member 32b is preferably two or more times the thickness, and more preferably five or more times the thickness, of the wiring 52.

The second electrode 22 of the solar cell 20G positioned at the far x1 end of the first solar cell string 10a and the first electrode 21 of the solar cell 20L positioned at the far x1 end of the sixth solar cell string 10f are connected electrically by a third wiring member 33. The solar cells 20G, 20L and the third wiring member 33 are bonded via an adhesive layer 40.

The third wiring member 33 has wiring member 32a and wiring member 33b. Wiring member 32a comprises a portion of the third wiring member 33, and has a configuration substantially similar to wiring member 32a composing a portion of the second wiring member 32. Wiring member 32a composing a portion of the third wiring member 33 is bonded to and connects electrically the second electrode 22 of solar cell 20G and the first electrode 21 of solar cell 20L.

Wiring member 33b is connected electrically to wiring member 32a composing a portion of the third wiring member 33. A portion of wiring member 33b comprises an extraction electrode 42 which is drawn from the solar module 1.

Wiring member 33b is connected electrically to wiring 52 in the second portion 32a2 of the wiring member 32a composing a portion of the third wiring member 33. Wiring member 33b may be bonded to wiring member 32a using a resin adhesive. However, in the present embodiment, it is bonded to the wiring member 32a using solder and is connected electrically to the wiring 52 of the wiring member 32a. The wiring member 33b is bonded to a portion of the wiring member 32a in the other direction (the y-axis direction).

In the present embodiment, wiring member 33b is composed of metal foil made of at least one type of metal such as Cu or Ag. The thickness of the wiring member 33b is greater than the thickness of the wiring 52. The thickness of the wiring member 33b is preferably two or more times the thickness, and more preferably five or more times the thickness, of the wiring 52.

An insulating sheet 60 is arranged between the wiring 32b, 33b composed of metal foil and the back surface 20b of the solar cell 20. In this way, short circuiting between the wiring 32b, 33b and the electrodes 21, 22 can be suppressed. The insulating sheet 60 can be composed of the resin used in the resin film 51 (PI, PET, etc.) or can be the resin used in the sealing material layer 13 (EVA, PVB, PE, PU, etc.).

In the present invention, as mentioned above, a bent portion 32a3 is arranged on the solar cells 20. When the solar cells 20 are laminated in the sealing material layer 13 between the first protecting member 11 and the second protecting member 12, the temperature of the solar module 1 rises and the viscosity of the sealing material layer 13 containing a non-crosslinked resin decreases. Even when pressure is applied by the bending portion 32a3 towards the solar cells 20, the section of the wiring 52 positioned on the bending portion 32a3 is unlikely to make contact with the edge 23c of the photoelectric conversion unit 23. This effectively prevents short circuiting between the section of the wiring 52 positioned on the bent portion 32a3 and the photoelectric conversion unit 23. As a result, improved photoelectric conversion efficiency and improve reliability can be realized.

By arranging the bent portion 32a3 on the solar cells 20, the size of the wiring member 32a can be reduced. Therefore, the manufacturing costs for the solar module 1 can be kept down.

By arranging the bent portion 32a3 on the solar cells 20, the size of the solar module 1 can also be reduced.

In the present invention, the wiring members 32, 33 are composed of wiring member 32a and either wiring member 32b made of metal foil or wiring member 33b. In this way, the wiring members 32, 33 can share the same specifications as the wiring member 32a of resin film 51 and wiring 52, even when many different types of wiring members 32, 33 are present.

In the present embodiment, the wiring members 32b, 33b of metal foil are bonded to a portion of the wiring member 32a in the y-axis direction. As a result, the wiring members 32b, 33b and the solar cells 20 are unlikely to be subjected to stress, even when the temperature of the solar module 1 rises and the wiring members 32b, 33b expand more than the solar cells 20. In this way, damage to the wiring members 32b, 33b and damage to or warping of the solar cells 20 can be suppressed. Because the wiring member 32a uses flexible resin film 51 as its substrate, a large amount of stress caused by thermal expansion is less likely to occur between the wiring member 32a and the solar cells 20.

During the connection process, wiring members 32b and 33b are preferably fixed to wiring member 32a by placing a heat-resistant sheet over the solar cells 20, and soldering wiring member 32a to wiring members 32b and 33b on the heat-resistant sheet. This suppresses the application of heat from the soldering to the solar cells 20 and can prevent problems caused by failure. The insulating sheet 60 arranged between the wiring members 32b, 33b and the back surface 20b of the solar cells 20 may have heat-resistant properties. In this case, however, the thickness of the insulating sheet 60 has to be reduced as the thick portions concentrate force during the modulization process which can cause the solar cells 20 to crack. Therefore, use of a separate heat-resistant sheet is preferred.

The present invention includes various embodiments not described herein. For example, the first electrode and the second electrode may be busbarless electrodes which have a plurality of finger portions but no busbar portion.

A solar module may also include a single solar cell.

The present invention includes many other embodiments not described herein. Therefore, the technical scope of the present invention is defined solely by the items of the invention specified in the claims pertinent to the above explanation.

### Modified Example

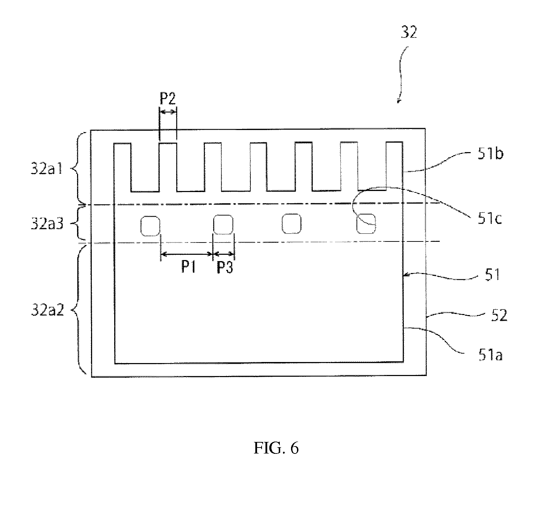

FIG. 6 is an expanded view of the wiring member 32 in a modified example. As shown in FIG. 6, the wiring 51 has a wiring main body 51a and a plurality of linear portions 51b. In the wiring member 32, a second portion 32a2 and a bent portion 32a3 are provided in at least the wiring main body 51a. The linear portions 51b are connected to the wiring main body 51a. The linear portions 51b are interdigitated in the y-direction. The linear portions 51b are connected electrically to finger portions 21a or finger portions 22a.

A plurality of openings 51c are provided in the wiring 51 in the bent portion 32a3 of the wiring member 32. The openings 51c are arranged in the y-direction, which is the direction in which the bent portion 32a3 extends. This improves the flexibility of the bent portion 32a3. This makes it easier to bend a flat member when the flat member is bent to form wiring member 32. This makes the wiring member 32 easier to manufacture. Also, when a flat member is bent to create a wiring member 32 and stress is applied to the bent portion repeatedly over the temperature cycle, the wiring 32 is unlikely to become disconnected. Because openings 51c are provided in the wiring main body 51a and the bent portion 32a3 is formed in the portion with the wiring main body 51a, disconnected wiring 32 is prevented even more effectively. Because the spacing P1 of the openings 51c is greater than the width P2 of the linear portions 51b, disconnected wiring 32 is prevented even more effectively. The spacing P1 of the openings 51c should be greater than the width P2 of the linear portions 51b, and preferably at least 1.5 times greater. From the standpoint of preventing disconnected wiring 32, the width P3 of each opening 51c is preferably smaller than the spacing P1 between openings 51c.

In the present modified example, the openings 51c have a rounded rectangular shape to facilitate bending and prevent disconnection. However, there are no particular restrictions on the shape of the openings. The shape of the openings may be elliptical, oval shaped, rectangular or polygonal. The openings may also have a slender shape which extends in the direction in which the bent portion 32a3 extends. A single opening 51c may be provided.

### Key to the Drawings

1: Solar module
10, 10a-10f: Solar cell strings
11: 1 st protecting member
12: 2nd protecting member
13: Sealing material layer
20, 20A-20L: Solar cells
20a: Light-receiving surface
20b: Back surface
21: 1st electrode
22: 2nd electrode
23: Photoelectric conversion unit
31-33, 32a, 32b, 33b: Wiring members
32a1: 1st portion
32a2: 2nd portion
32a3: Bent portion
51: Resin film
52: Wiring
60: Insulating sheet

## Claims

1. A solar module comprising:
a solar cell having a photoelectric conversion unit with a first main surface and a second main surface, and a first electrode and a second electrode arranged on the second main surface; and
a wiring member having resin film, and wiring arranged on the resin film and connected electrically to either the first electrode or the second electrode;
the wiring member having
a first portion arranged so the wiring faces the solar cell side and is bonded to the solar cell,
a second portion arranged so the wiring faces the reverse side from the solar cell, and
a bent portion connecting the first portion and the second portion,
the bent portion being arranged on the solar cell.

2. The solar module according to claim 1 further comprising metal foil connected electrically to the wiring in the second portion,
the wiring being arranged on an end portion of the solar cell in one direction from one side to the other side of the end portion in another direction orthogonal to the one direction, and
the metal foil is bonded to a portion of the wiring in the other direction.

3. The solar module according to claim 2, wherein the metal foil is thicker than the wiring.

4. The solar module according to claim 2, wherein the metal foil is drawn from the solar module.

5. The solar module according to claim 2, wherein a plurality of solar cells are connected electrically by wiring members, and the metal foil connects the wiring members to each other.

6. The solar module according to claim 1 further comprising:
a first protecting member arranged on the first main surface side of the solar cell;
a second protecting member arranged on the second main surface side of the solar cell and having flexibility; and
a sealing material layer arranged between the first protecting member and the second protecting member, and sealing the solar cell.

7. The solar module according to claim 6, wherein the sealing material layer includes a non-crosslinked resin.

8. The solar module according to claim 1, wherein an opening is provided in the wiring in the bent portion.

9. The solar module according to claim 8, wherein a plurality of openings is provided.

10. The solar module according to claim 9, wherein each of the first electrode and the second electrode include a plurality of interdigitated finger portions,
the wiring has
a wiring main body provided with openings, and
a plurality of linear portions connected to the wiring main body and connected electrically to the finger portions, and
the spacing of the openings is greater than the width of the linear portions.
